Europäisches Patentamt

European Patent Office

Office européen des brevets

(19)

(11) Veröffentlichungsnummer: **0 125 390**

**A1**

(12) **EUROPÄISCHE PATENTANMELDUNG**

(21) Anmeldenummer: 84101208.1

(22) Anmeldetag: 07.02.84

(51) Int. Cl.³: **H 01 L 29/66**
H 01 L 31/02, H 01 L 31/08
H 01 L 31/18

(30) Priorität: 15.03.83 DE 3309091

(43) Veröffentlichungstag der Anmeldung:
21.11.84 Patentblatt 84/47

(84) Benannte Vertragsstaaten:
AT BE CH DE FR GB IT LI NL SE

(71) Anmelder: Schaumburg, Hanno, Prof. Dr.-Ing.
Dörpsweg 47
D-2000 Hamburg 54(DE)

(72) Erfinder: Schaumburg, Hanno, Prof. Dr.-Ing.
Dörpsweg 47
D-2000 Hamburg 54(DE)

(74) Vertreter: Dickel, Klaus, Dipl.-Ing.
Julius-Kreis-Strasse 33
D-8000 München 60(DE)

(54) Semitransparente Sensoren sowie deren Herstellung und Anwendung.

(57) Ein Sensor mit einer auf einem Substrat aufgebrachten Sensorschicht ist semitransparent ausgebildet, zur Intensitätsmessung einer Strahlung, ohne daß diese hierbei wesentlich absorbiert wird. Die physikalischen Eigenschaften der Sensorschicht, und hier im besonderen der elektrische Widerstand, ist durch Bestrahlung von außen veränderbar. Es können mehrere Sensorschichten kammstrukturartig hintereinander angeordnet sein. Anwendungsgebiete sind die Intensitätsmessung von Strahlung, Steuerung der Strahlungsintensität, sowie ortsaufgelöste Intensitätsmessung.

FIG.2

EP 0 125 390 A1

Semitransparente Sensoren sowie deren Herstellung und
Anwendung

---

Die Erfindung betrifft Sensoren mit einer auf einem
Substrat aufgebrachten Sensorschicht sowie die Herstellung
und Anwendung derselben.

Bei der herkömmlichen Intensitätsmessung elektromagnetischer
Strahlen werden sog. Beam-Splitter-Verfahren eingesetzt,
bei denen Strahlung in einem Beam-Splitter in zwei Komponenten
aufgeteilt sind. Während ein Anteil weiterverarbeitet wird,
führt man den zweiten Anteil auf eine photoempfindliche Meßzelle, welche die Intensität der Strahlung mißt und ein Ausgangssignal erzeugt. Es zeigt sich, daß hierfür der Aufwand
erheblich ist.

Der Erfindung liegt die Aufgabe zugrunde, einen Sensor so
auszubilden, daß die Intensitätsmessung einer Strahlung ermöglicht wird, ohne daß dabei eine Aufspaltung des Strahles
erforderlich ist und diese dabei wesentlich absorbiert
wird. Gelöst wird diese Aufgabe durch die im Kennzeichen des
Hauptanspruches angegebenen Merkmale. Hinsichtlich bevorzugter
Ausführungsformen wird auf die Unteransprüche verwiesen.

Nach der Erfindung sind das Substrat und die Sensorschicht
semitransparent. Wird eine elektromagnetische Strahlung auf den
Sensor gerichtet, so wird nur ein geringer Teil dieser Strahlung
durch die Schicht und das Substrat absorbiert. Ein wesentlicher anderer Teil durchdringt den Sensor und kann nach Durchlaufen desselben für weitere Zwecke eingesetzt werden.

In der Sensorschicht tritt eine Wechselwirkung mit der
elektromagnetischen Strahlung ein, welche Veränderungen in den physikalischen Eigenschaften der Schicht bewirkt. Diese Wechselwirkung ist jedoch nicht so stark, daß die elektromagnetische Strahlung hier vollständig absorbiert wird. Ein erheblicher Teil durchdringt die Schicht und das Substrat nur wenig geschwächt und steht dementsprechend für eine weitere Verwendung zur Verfügung.

Gemäß einer bevorzugten Ausführungsform ändert sich der elektrische Widerstand der Sensorschicht aufgrund der auftreffenden Strahlung. Die Änderung des Widerstandes wird dadurch erfaßt, daß in oder auf die Schicht Kontaktgebiete eingebracht werden, welche über Kontaktspitzen oder Leiterbahnen mit der Außenwelt verbunden werden.

Eine Änderung des elektrischen Widerstandes des Gebietes der Sensorschicht wird damit über eine Änderung des Widerstandes zwischen den Kontaktgebieten gemessen, also durch Änderung des Stromes, wenn eine Spannungsquelle angebracht wird.

Die Schicht kann aus einer aufgedampften, aufgesputterten oder durch eine chemische Ausscheidung aus der Gasphase (CVD Chemical-Vapour-Deposition) niedergeschlagenen Schicht bestehen. Das Material der Schicht kann halbleitend sein.

Vorzugsweise besteht das Substrat aus Quarzglas, während die Sensorschicht aus polykristallinem Silicium besteht. Nach einer Ausführungsform der Erfindung kann die Sensorschicht zwischen zwei semitransparenten, hochleitfähigen Schichten angeordnet sein. Diese sind über eine Metallisierung mit Außenkontakten verbunden.

Gemäß der Erfindung können die Kontaktgebiete in der Sensorschicht eine ineinandergreifende Fingerstruktur (Kammstruktur) aufweisen. Andererseits können die Kontaktgebiete auch ringförmig ausgebildet sein.

Gemäß einer besonders bevorzugten Ausführungsform sind mehrere Sensorschichten isoliert voneinander hintereinander angeordnet. Hierdurch läßt sich eine ortsaufgelöste Intensitätsmessung durchführen.

Bei der Herstellung der Sensoren bringt man auf das beschichtete Glassubstrat eine isolierende Schicht auf, die man über photolithographische Beschichtungs- und Ätzverfahren in den Kontaktgebieten entfernt, worauf man durch Einbringen von Dotierungsatomen den Widerstand der Polysiliciumschicht in diesen Gebieten verkleinert und eine Leiterverbindung nach außen herstellt. In den Kontaktgebieten beträgt der Widerstand vorzugsweise etwa 30 Ohm/cm$^2$. Als Dotierungsatome verwendet man bevorzugt P, As und B.

Bevorzugte Anwendungsgebiete für die erfindungsgemäßen Sensoren sind die Intensitätsmessung von elektromagnetischer Strahlung oder Lichtstrahlung, z.B. Laser, die Steuerung der Strahlungsintensität sowie eine ortsaufgelöste Intensitätsmessung, wodurch sich etwa die Lage eines Körpers im Raum kontrollieren läßt.

Weitere Einzelheiten, Vorteile und erfindungswesentliche Merkmale ergeben sich aus der nachfolgenden Beschreibung verschiedener Ausführungsbeispiele der Erfindung unter Bezugnahme auf die beigefügten Zeichnungen. Dabei zeigt im einzelnen:

Fig. 1    in schematischer Darstellung einen Schnitt durch einen Sensor, bestehend aus einem Substrat mit aufgebrachter Sensorschicht,

Fig. 2    eine der Fig. 1 entsprechende Darstellung mit Kontaktgebieten in der Sensorschicht und abführenden Leiterbahnen,

Fig. 3      einen Querschnitt durch einen Sensor zur Detektion lichtoptischer Strahlung,

Fig. 4      einen Schnitt durch eine andere Ausführungsform des Sensors zur Detektion lichtoptischer Strahlung,

Fig. 5      einen Schnitt durch einen Sensor, bei welchem sich der Photostrom aufgrund einer elektromagnetischen Strahlung ändert,

Fig. 6      einen Schnitt durch eine andere Ausführungsform des Sensors gemäß Fig. 5,

Fig. 7      einen Schnitt durch eine weitere Ausführungsform des Sensors gemäß Fig. 5,

Fig. 8      eine schematische Darstellung des erfindungsgemäßen Sensors zur Helligkeitsregelung von Lichtquellen,

Fig. 9      die Draufsicht auf einen Sensor gemäß den Fig. 1 bis 7,

Fig. 10      die Draufsicht auf eine weitere Ausführungsform des Sensors gemäß Fig. 9,

Fig. 11      in schematischer Darstellung die Anwendung des erfindungsgemäßen Sensors in einer optischen Anordnung,

Fig. 12      eine Sensorstruktur für eine ortsaufgelöste Intensitätsmessung,

Fig. 13      eine weitere Ausführungsform der Struktur nach Fig. 12, wobei (a) eine erste und b) eine zweite Sensorebene darstellt, und

Fig. 14      eine schematische Darstellung zur Messung der Lage von Laserstrahlen.

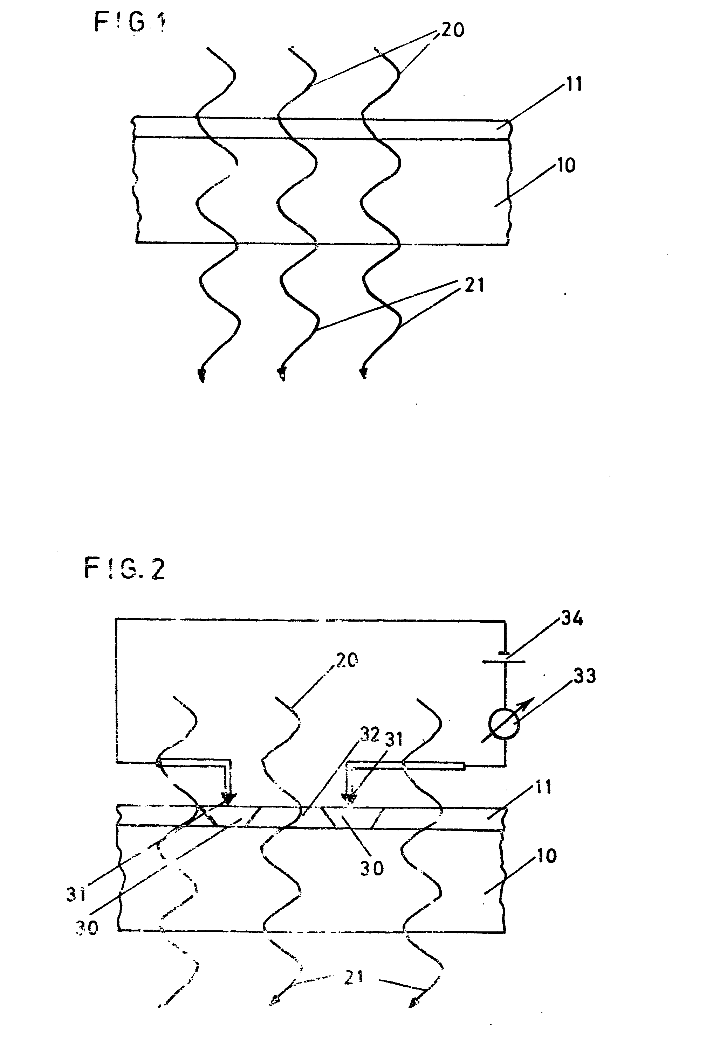

Zunächst soll anhand der Fig. 1 das Grundprinzip der Erfindung erläutert werden. Auf einem durchlässigen Substrat 10 ist eine Sensorschicht 11 aufgebracht. Wird eine elektromagnetische Strahlung 20 auf den Sensor gerichtet, dann wird ein Teil dieser Strahlung durch die Schicht 11 und das Substrat 10 absorbiert. Ein wesentlicher anderer Teil 21 durchdringt jedoch den Sensor und kann nach dessen Durchlaufen für weitere Zwecke eingesetzt werden.

In der Sensorschicht 11 tritt eine Wechselwirkung mit der elektromagnetischen Strahlung ein, welcher Veränderungen in den physikalischen Eigenschaften der Schicht 11 bewirkt. Diese Wechselwirkung ist jedoch nicht so stark, daß die elektromagnetische Strahlung hier vollständig absorbiert wird. Es ist im Gegenteil wünschenswert, daß ein erheblicher Teil die Schicht 11 und das Substrat 10 nur wenig geschwächt durchdringt.

Nachfolgend sollen verschiedene Ausführungsformen des erfindungsgemäßen Sensors näher beschrieben werden.

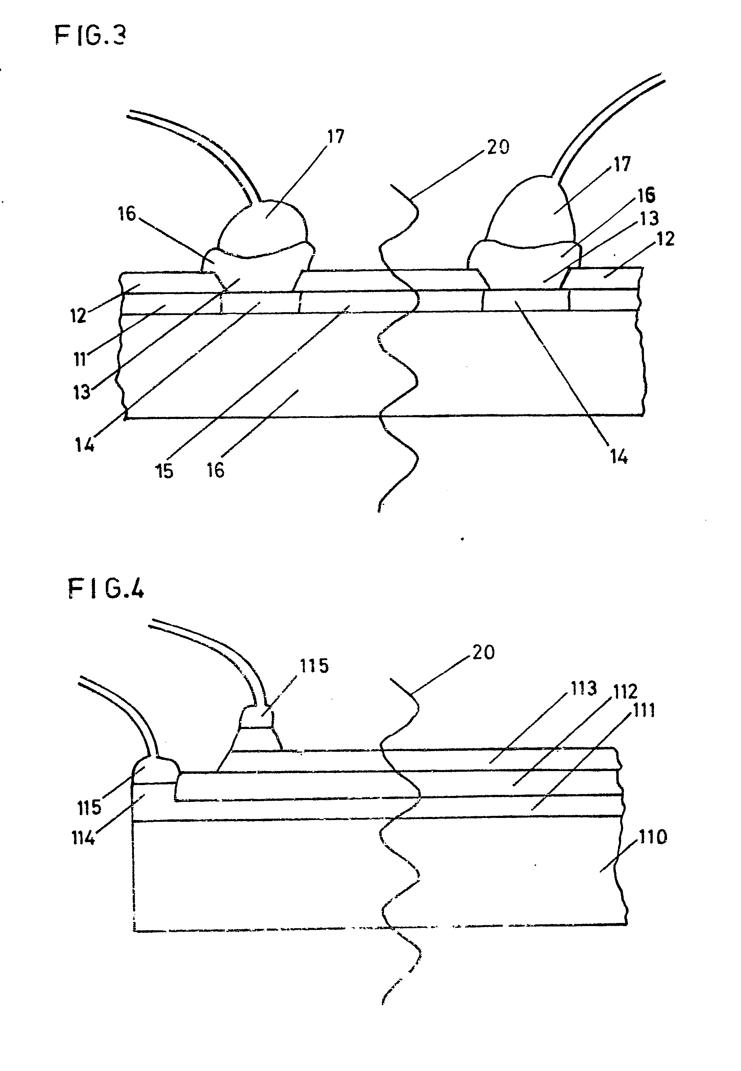

Die Fig. 2 zeigt in schematischer Darstellung den Aufbau einer bevorzugten Ausführungsform des Sensors. Die Wirkung der elektromagnetischen Strahlung 20 ist eine Änderung des elektrischen Widerstandes der Sensorschicht 11. Die Änderung des Widerstandes wird dadurch erfaßt, daß in oder auf die Schicht 11 Kontaktgebiete 30 eingebracht werden, welche über Kontaktspitzen oder Leiterbahnen 31 mit der Außenwelt verbunden werden.

Eine Änderung des elektrischen Widerstandes des Gebietes 32 der Sensorschicht 11 wird damit über eine Änderung des Wider-

standes zwischen den Kontaktgebieten gemessen; also durch Änderung des Stromes 33, wenn eine Spannungsquelle 34 angebracht wird.

Die Schicht 11 kann aus einer aufgedampften, aufgesputterten oder durch eine chemische Abscheidung aus der Gasphase (CVD Chemical-Vapour-Deposition) niedergeschlagenen Schicht bestehen. Das Material der Schicht kann halbleitend sein.

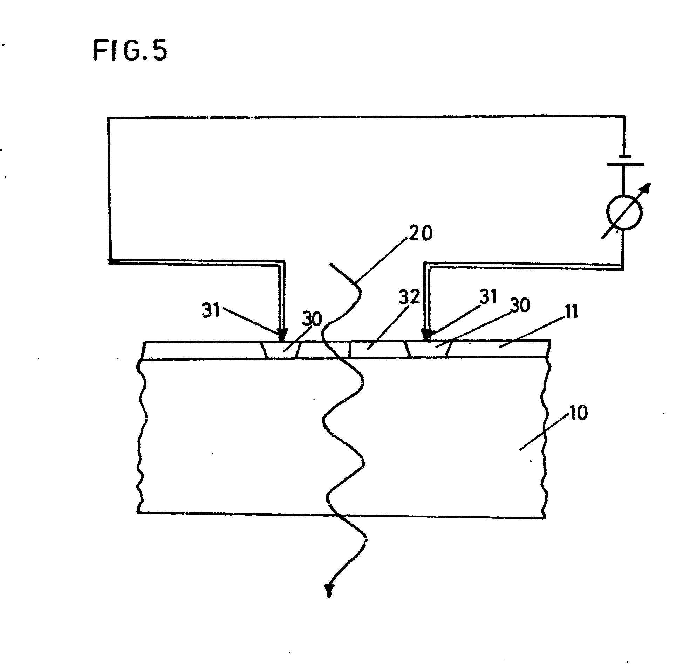

Die Fig. 3 zeigt eine Ausführungsform, bei welcher lichtoptische elektromagnetische Strahlen durch semitransparente polykristalline Siliciumschichten detektiert werden können.

Auf einer polierten Scheibe 10 aus Quarzglas (bevorzugte Dicke 0,3 bis 1 mm) wird über die bekannten CVD-Verfahren (z. B. Silan-Pyrolyse bei $650^{\circ}C$) eine dünne Schicht 11 aus polykristallinem Silizium niedergeschlagen. Bevorzugte Dicke beträgt 0,1 bis 1 $\mu$m. Auf diese Art beschichtete Quarzglasträger sind je nach Dicke der Siliziumschicht für optische Strahlung mehr oder we-niger transparent.

In einem folgenden Bearbeitungsschritt wird eine isolierende Schicht 12 (bevorzugte Ausführung $SiO_2$ oder $Si_3N_4$ der Dicke 0,1 bis 1 $\mu$m) aufgebracht. (Bevorzugte Ausführungen Aufdampfen, CVD, thermische Oxidation). Über bekannte photolithographische Belichtungs- und Ätzverfahren wird an den Stellen 13 die Isolierschicht wieder entfernt.

Anschließend wird durch gezieltes Einbringen von Dotierungsatomen (bevorzugtes Verfahren thermische Diffusion und Ionenimplantation) der Widerstand der Polysiliziumschicht in den Kontaktgebieten 14 stark verkleinert (bevorzugter Schichtwiderstand 30 Ohm/$cm^2$, Dotierungsatome P, As, B). Der Teil 15 der Sensorschicht zwischen den Kontaktgebieten 14 verbleibt praktisch unbeeinflußt. Die Kontaktgebiete 14 werden nach bekannten Verfahren (Aufdampfen einer leitfähigen Schicht,

0125390

anschließende Strukturierung) metallisiert, so daß über einen Teil der Kontaktgebiete leitfähige Gebiete der Form 16 angebracht sind. Diese können nach bekannten Bondverfahren mit Außenkontakten 17 verbunden werden.

Gemessen wird der elektrische Widerstand zum Kontakt 17, der von der Stärke der Strahlung S abhängt. Zum Schutz der Sensorstruktur wird abschließend eine Passivierung aus einer $SiO_2$- und $Si_3N_4$- oder einer anderen durchlässigen Schicht aufgebracht.

Wichtig für die optischen Eigenschaften des beschriebenen semitransparenten Sensors sind die Eigenschaften der Polysiliziumschicht 11, insbesondere an der Stelle 15. Die Eigenschaften der Polysiliziumschicht können beeinflußt werden durch Bearbeitungsverfahren wie

1) Variation der Abscheidungsbedingungen
2) Temperaturbehandlung
3) Dotierung durch Fremdatome
4) Lokales Aufheizen oder lokales Aufschmelzen durch Laser oder andere Wärmequellen
5) Andere Verfahren.

Auf diese Weise können die Eigenschaften der Schicht, wie optische Transparenz, Widerstandsänderung, durch Bestrahlung und viele andere beeinflußt werden.

Besondere Ausführungsformen entstehen durch das Weglassen der Kontaktdotierung in den Gebieten 14 sowie durch eine Metallisierung der Gebiete 13 mit optisch transparenten Elektroden.

Eine weitere Ausführungsform ist in Fig. 4 dargestellt. Hierbei ist die Sensorschicht 112 zwischen zwei semitransparenten, hochleitfähigen Schichten ... und 113 angeordnet. Diese sind wiederum über eine Metallisierung 114 und Außenkontakten 115 verbunden.

In einer bevorzugten Ausführung besteht das Substrat 110 aus einer Quarzglasscheibe, die Schichten 111 und 113 aus hochdotiertem Polysilizium und die Schicht 112 aus niedrigdotiertem Polysilizium. Gemessen wird auch bei diesem Sensor der Widerstand zwischen den Kontakten 15, der abhängt von der Intensität der Strahlung S.

Die Fig. 5 zeigt den prinzipiellen Aufbau eines Sensors, bei welchem eine Änderung des Photostroms aus einer Sensorschicht eintritt, aufgrund einer elektromagnetischen Strahlung.

Die Wirkung der elektromagnetischen Strahlung 20 ist die Erzeugung eines Photostroms durch Ladungstrennung von Elektron-Lochpaaren. Der Aufbau der Sensoren ist grundsätzlich so, wie dies im Zusammenhang mit den Fig. 3 und 4 beschrieben worden ist, jedoch sind in den Sensorschichten ladungstrennende Strukturen (bevorzugte Ausführung pn-Übergang oder Schottky-Übergang) eingebracht. Diese Strukturen lassen sich mit bekannten Dotierungs- und Metallisierungstechniken herstellen.

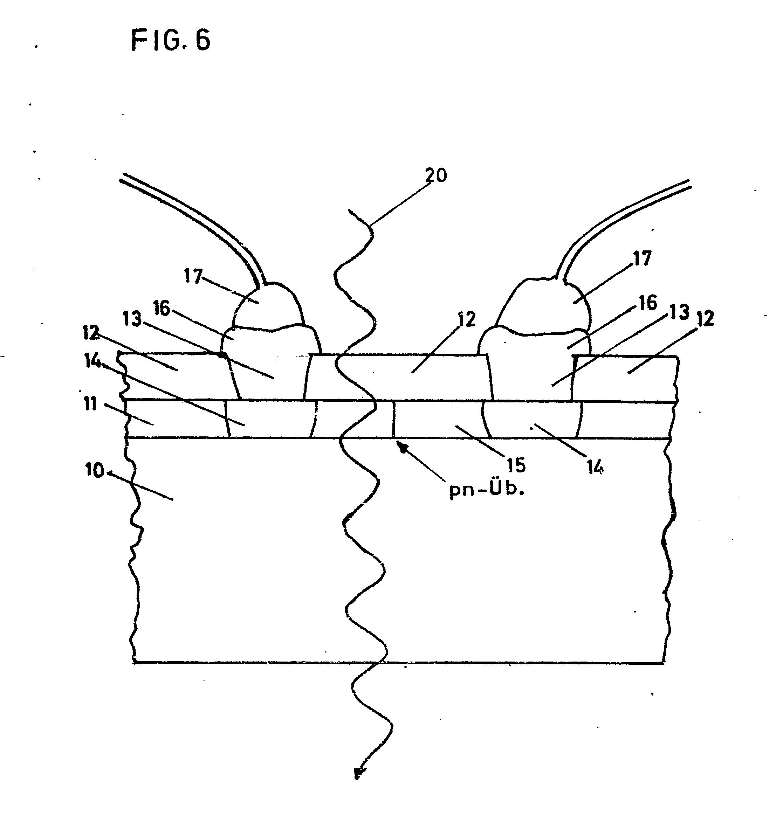

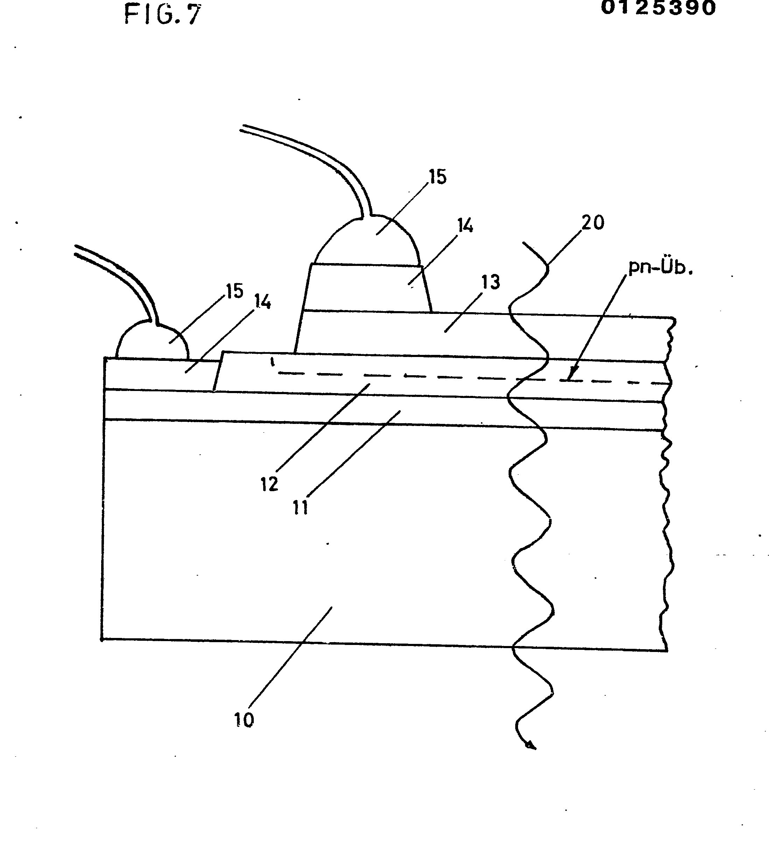

In den Fig. 6 und 7 sind weitere bevorzugte Ausführungsformen der Anordnung, wie sie grundsätzlich in Fig. 5 dargestellt ist, gezeigt, wobei die Bezugszeichen die gleiche Bedeutung wie in den Fig. 2 bis 4 besitzen.

Der anwendungstechnische Vorteil der oben beschriebenen Sensoren liegt darin, daß die Intensität einer elektromagnetischen Strahlung gemessen werden kann, ohne daß die Strahlung durch die Messung vollständig oder größtenteils absorbiert wird.

Dabei läßt sich, verglichen mit dem Stand der Technik, diese Intensitätsmessung mit einem wesentliche geringeren Aufwand erreichen. Die Strahlung wird durch einen Sensor hindurchgeleitet, der unmittelbar das Ausgangssignal $U_s$ liefert. Nach Passieren des Sensors kann die Strahlung

weiterverarbeitet werden.

Es sollen nachfolgend einige bevorzugte Anwendungsmöglichkeiten des erfindungsgemäßen Sensors beschrieben werden.

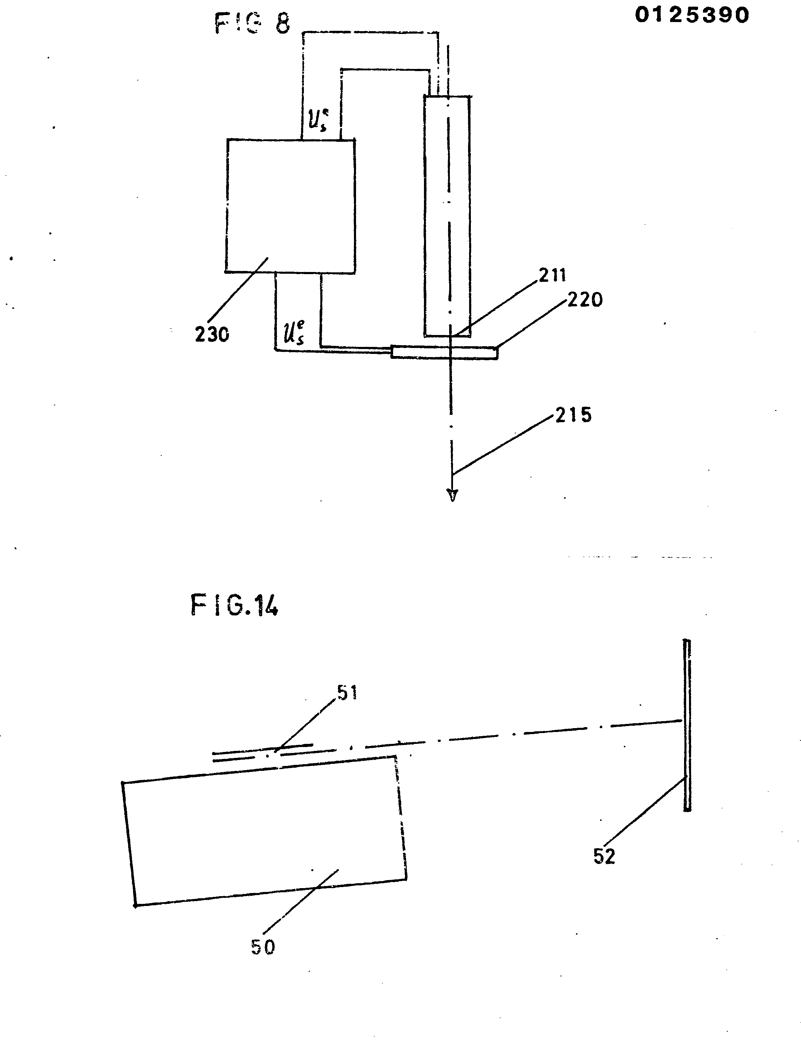

Ein wichtiges Anwendungsgebiet der erfindungsgemäßen Sensoren
ist die Helligkeitsregelung von Lichtquellen, insbesondere
Lasern. Der Aufbau dieser Anwendung ist schematisch in Fig. 8
dargestellt. In der Nähe des Austrittsfensters 211 des Laserstrahls 215 ist ein lichtempfindlicher Sensor 220 mit dem
weiter oben beschriebenen Aufbau angeordnet. Das Ausgangssignal
$U^e_s$ des Sensors wird einer Regelelektronik 230 zugeführt, über
deren Ausgangssignal $U^a_s$ die Intensität des Laserstrahls 215 gesteuert wird.

Dabei kann der erfindungsgemäße Sensor entweder auf einer
Quarzplatte aufgebracht sein, die unmittelbar vor dem Austrittsfenster angeordnet ist. Alternativ dazu kann der Sensor
aber auch unmittelbar auf dem Austrittsfenster angeordnet
sein, d.h. die zur Herstellung des Sensors erforderlichen Verfahrensschritte werden auf dem Austrittsfenster selbst durchgeführt. Anschließend wird die Sensoroberfläche durch eine
lichtdurchlässige Passivierungsschicht geschützt.

Der Vorteil der Anordnung, wie sie in Fig. 8 dargestellt ist,
gegenüber den Problemlösungen nach dem Stand der Technik,
liegt darin, daß in der erfindungsgemäßen Ausführungsform
gemäß Fig. 8 weniger Glasoberflächen auftreten, welche in
der Praxis kontinuierlich gewartet werden müssen. Gleichzeitig erforder die Anordnung gemäß Fig. 8 einen geringeren
Aufwand und ist kostengünstiger.

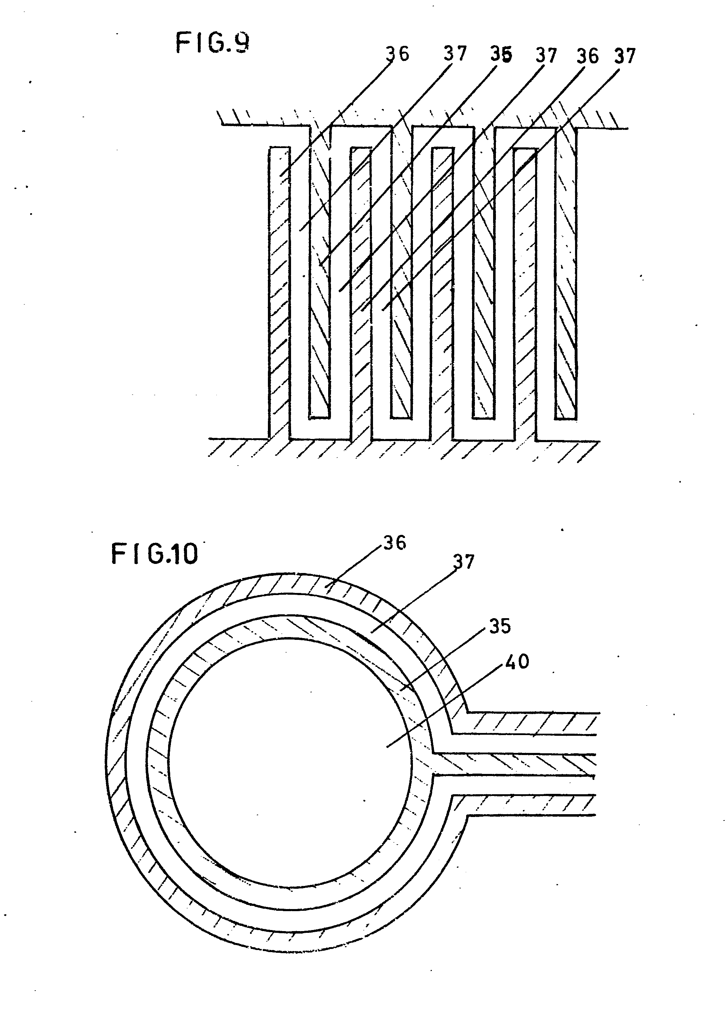

Von Bedeutung ist die laterale Struktur des lichtempfindlichen
Sensors (in den bisherigen Abbildungen wurden nur Querschnittsstrukturen gezeigt). Die Fig. 9 zeigt die Draufsicht auf
einen Sensor, der in den Fig. 1 bis 7 beschrieben ist. In
die Sensorschicht 11 haben die Kontaktgebiete eine ineinander-

greifende Fingerstruktur. d.h. die beiden Kontaktgebiete
35 und 36 besitzen die in Fig. 9 dargestellte Form.

Der Widerstand zwischen den Kontakten 35 und 36 wird durch
die dazwischenliegenden Gebiete 37 bestimmt. Fällt auf die
Gebiete 37 eine elektromagnetische Strahlung, dann verändern
(z. B. verkleinern) diese Gebiete ihren elektrischen Widerstand. Je mehr Strahlung auf Gebiete des Typs 37 fällt, desto
niedriger wird der Gesamtwiderstand zwischen den Kontakten
35 und 36.

Eine andere laterale Struktur ist in Fig. 10 dargestellt. Hierbei sind die Kontaktgebiete 35 und 36 ringförmig ausgeführt.
Zwischen den Kontaktringen liegt die photoempfindliche Schicht
37. Im mittleren Gebiet 40 kann der Sensor völlig transparent
sein, so daß eine Intensitätsmessung nur in den äußeren Gebieten eines kreisförmigen Strahlquerschnitts durchgeführt
wird.

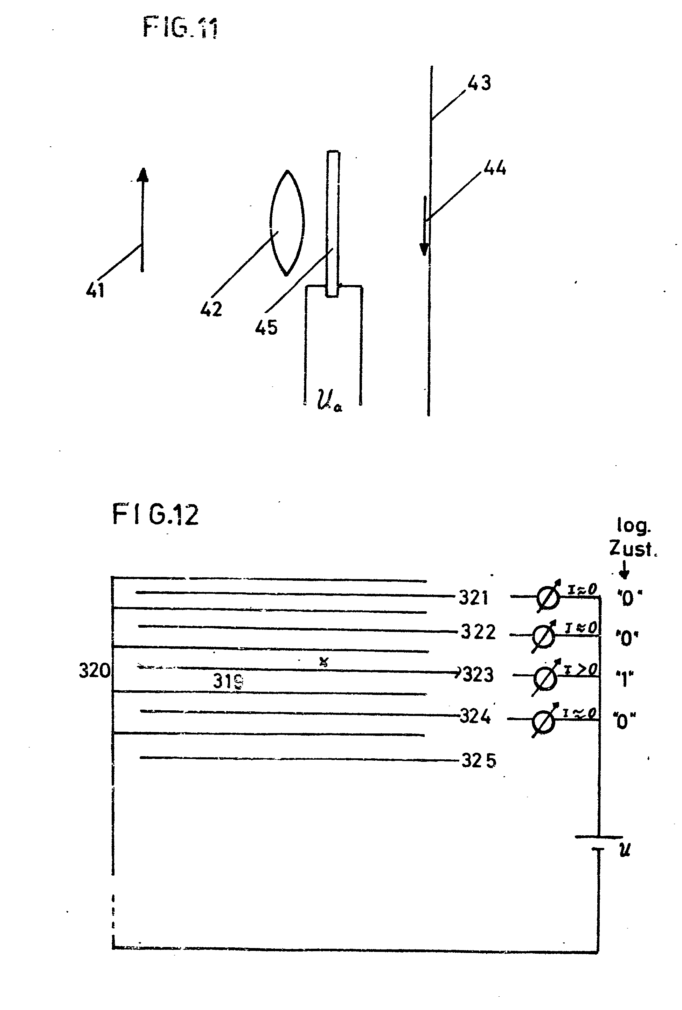

Die Fig. 11 zeigt die Anwendung des erfindungsgemäßen Sensors
in einer optischen Anordnung, wie sie z.B. für die Zwecke der
Photographie von Interesse ist. In Fig. 11 wird ein Gegenstand
41 über eine Linse 42 auf einem Film 43 abgebildet. Er erzeugt dort das Bild 44. Ordnet man zwischen Linse und Film
einen erfindungsgemäßen Sensor 45 an, so kann dieser ein Ausgangssignal Ua abgeben, das mit der integrierten Helligkeit
korreliert, mit der der Gegenstand 41 auf dem Film 43 abgebildet wird. Das Signal aus dem Sensor 45 kann z. B. zur
Steuerung der Belichtungsdauer herangezogen werden.

Die laterale Struktur dieses Sensors kann die in den Fig. 10
und 11 dargestellte, aber auch eine andere Form besitzen.

Ein wesentliches Kennzeichen des erfindungsgemäßen Sensors
ist die Tatsache, daß der Sensor semitransparent ist, d.h.
daß ein wesentlicher Teil der Strahlung den Sensor wieder
verläßt. Das eröffnet die Möglichkeit, mehrere Sensoren mit verschiedenen Strukturen hintereinander anzuordnen. Auf
diese Weise ist, bei geeigneter Zusammenführung verschiedener
Sensoren, eine ortsaufgelöste Intensitätsmessung möglich.

Ausgegangen wird wieder von einer Kammstruktur gemäß Fig. 12,
die ähnlich ist, wie die der Fig. 9. Zur Vereinfachung sind
die Kontakt- bzw. Leiterbahnen als Striche gezeichnet. Einem
gemeinsamen Kontakt 320 sind die Einzelkontakte 321, 322, 323,
324, 325...... gegenüber angeordnet. Zwischen den Kontakten
liegt die strahlungsempfindliche Schicht 319, die z.B. ihren
Widerstand bei Bestrahlung stark absenkt.

Gemessen wird die Leitfähigkeit zwischen dem gemeinsamen
Kontakt 320 und den Einzelkontakten. Trifft z.B. in Abbildung
12 an dem mit einem Kreuz markierten Ort ein intensiver Lichtstrahl auf, dann fließt über den Kontakt 323 ein Strom. Man
kann diesem damit einen logischen Zustand "1" zuordnen, während
alle anderen Kontakte den logischen Zustand "0" besitzen. Aus
einer Zusammenstellung der logischen Zustände lassen sich
logische "Wörter" bilden; jedes Wort beschreibt dann genau das
Vorhandensein und die Lage eines Bildflecks, nämlich dem
Kreuz in Abbildung 12.

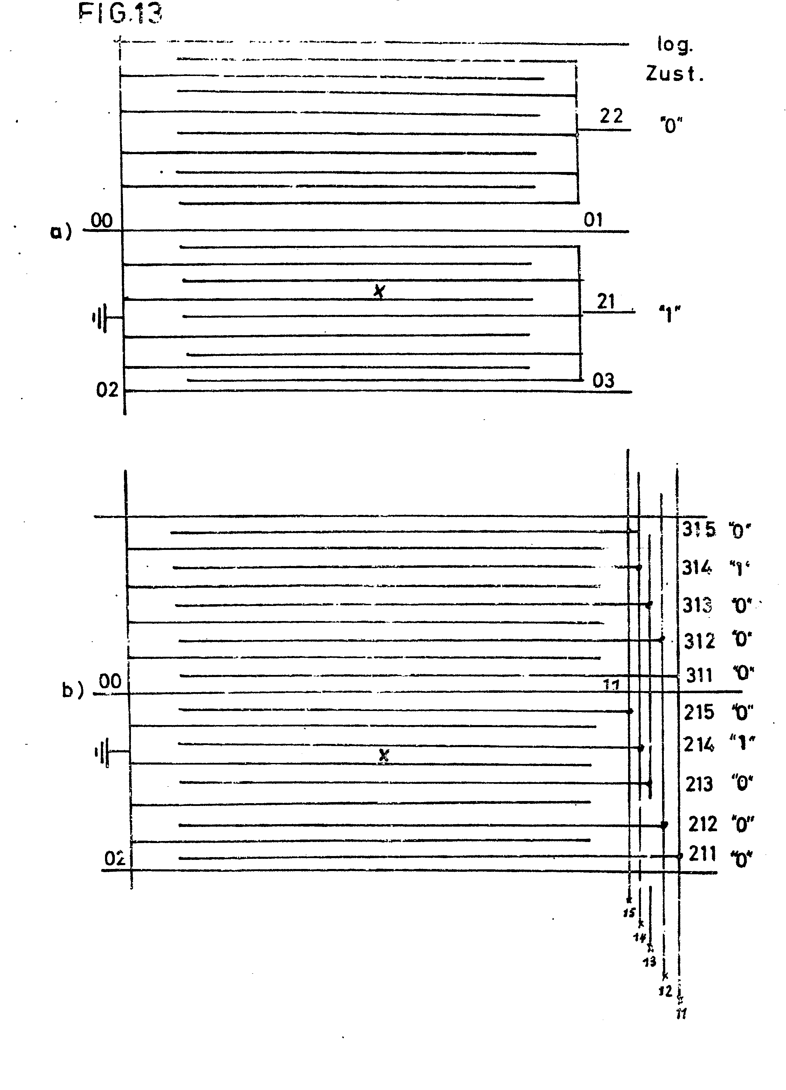

Durch die Anordnung von zwei erfindungsgemäßen Sensoren hintereinander - die wegen der Semitransparenz beide gleichzeitig
ansprechen - läßt sich die Ortsbestimmung für den Lichtfleck
wesentlich vergrößern. Das Prinzip ist in Abbildung 13 dargestellt. Beide Sensoren bestehen aus parallelen Leiterbahnen
derselben Abmessungen, die genau übereinander justiert werden,
so daß die Punkte 00 bis 03 genau übereinander liegen. In
der rechten Sensorebene sind die Einzelkontakte auf der
rechten Seite miteinander leitend verbunden, wie eingezeichnet,
d.h. 211 mit 311, 212 mit 312 usw.

Fällt ein Lichtstrahl auf die mit einem Kreuz markierten
Stelle ein, dann gilt:

1. Ebene　　　　　Zustand 21 = "1" alle anderen "0"

2. Ebene　　　　　Zustand 214 = "1" alle anderen "0"

In diesem Beispiel gelingt es also, 25 verschiedene Positionen des Lichtflecks mit zwei 5-Bit-Wörtern exakt zu beschreiben. Allgemein gilt: Bestehen die Wörter aus b Bits und liegen n Ebenen vor, dann ist eine digital genaue Ortsbestimmung des Lichtflecks für

$$N = b^n$$

Positionen möglich. Die Zahl der zur Beschreibung erforderlichen Worte ist n, die Anzahl der erforderlichen Bits b.n.

Bei b = 10 und n = 10 lassen sich mit 100 Bits $10^{10}$ Positionen exakt bestimmen.

Für eine zweidimensionale Ortsbestimmung müssen die Leiterbahnen der einzelnen Ebenen senkrecht zueinander angeordnet sein.

Eine Erweiterung dieser Erfindung ist die elektronische Einschaltung von Unterebenen. Beispiel: Nur wenn der Kontakt 21 den logischen Zustand "1" hat, wird die dazugehörige Unterebene der Kontakte 211 bis 215 auf die gemeinsame Leitung X11 bis X15 geschaltet. Andere Schaltungskombinationen zwischen den Kontakten und Unterebenen sind denkbar.

Die vorstehend beschriebenen Sensoren lassen sich mit denselben Techniken herstellen, wie dies zu Beginn der Beschreibung erläutert wurde. Für die Herstellung verschiedener Sensorebenen können mehrere Technologien eingesetzt werden.

1. Für jede Einzelebene wird ein Sensor gemäß Fig. 1 hergestellt, d.h. pro Ebene ist ein Quarzsubstrat erforderlich. Die einzelnen Sensoren müssen dann sorgfältig zueinander justiert werden.

2. Die ortsauflösenden Sensoren bestehen aus einer "Sandwich"-Struktur: auf einem Quarzsubstrat werden nacheinander Sensor- und Isolationsschichten aufgebracht, die bereits bei der Herstellung aufeinander justiert werden. Jede Sensorschicht besteht aus dem strahlungsempfindlichen Material, der Kontaktierung, der Verdrahtung der Kontaktierung und möglichen logischen Funktionen.

Bei allen Anordnungsverfahren muß jeweils die Sensorebene mit der feinsten geometrischen Auflösung an der der Strahlung zugewendeten Seite liegen, da bei dem Durchlaufen mehrerer Ebenen die Strahlung geschwächt und das Strahlenbündel aufgeweitet wird.

Wichtige Anwendungen der ortsaufgelösten Intensitätsmessungen ergeben sich in Verbindung mit starken Lichtquellen, wie z.B. Lasern.

So läßt sich beispielsweise die Messung der Lage von Laser-Strahlen durchführen. In Abb. 14 ist ein Körper 50 dargestellt, dessen Lage im Raum kontrolliert werden soll. Auf ihm ist ein Laser 51 fest verbunden angeordnet. In großem Abstand von dem Körper 50 befindet sich der erfindungsgemäße Sensor 52, welcher die Lage des Laserstrahls mit großer Genauigkeit digital mißt. Änderungen der Lage des Körpers 50 werden exakt erfaßt.

PATENTANWÄLTE

DR. KARL TH. HEGEL     -1-     DIPL.-ING. KLAUS DOELLNER

JULIUS-KREIS-STRASSE 33 · 8000 MÜNCHEN 60 · TELEFON (089) 88 52 10

ZUGELASSEN BEIM EUROPÄISCHEN PATENTAMT

TELEGRAMM-ADRESSE. DOELLNER-PATENT MÜNCHEN
FERNSCHREIBER. 52 16 739 dpat d

IHR ZEICHEN          UNSER ZEICHEN  H 3328          8000 MÜNCHEN, DEN

Prof. Dr. Hanno Schaumburg
Dörpsweg 47
2000 Hamburg 54

---

Semitransparente Sensoren sowie deren Herstellung und
Anwendung

---

Patentansprüche:

1. Sensor mit einer auf einem Substrat aufgebrachten Sensorschicht, d a d u r c h  g e k e n n z e i c h n e t , daß die
Sensorschicht (11) und das Substrat (10) semitransparent sind.

2. Sensor nach Anspruch 1, d a d u r c h  g e k e n n -
z e i c h n e t , daß die physikalischen Eigenschaften der
Sensorschicht (11) durch die Einwirkung von Licht und/oder
elektromagnetischen Wellen beeinflußbar sind.

3. Sensor nach Anspruch 2, d a d u r c h  g e k e n n -
z e i c h n e t , daß der elektrische Widerstand oder der

POSTSCHECKKONTO MÜNCHEN 8537 · BANK DELI · BRESNER 35 MÜNCHEN KTO NR 42 1991 (BLZ 700 700 10)

Photostrom der Sensorschicht (11) durch äußere Einwirkung veränderbar ist.

4. Sensor nach den Ansprüchen 1 bis 3, d a d u r c h g e k e n n z e i c h n e t , daß das Substrat (10) aus Quarzglas und die Sensorschicht (11) aus poylkristallinem Silizium bestehen.

5. Sensor nach einem der vorangehenden Ansprüche, d a - d u r c h g e k e n n z e i c h n e t , daß die Sensorschicht (112) zwischen zwei semitransparenten, hochleitfähigen Schichten (111) und (113) angeordnet sind.

6. Sensor nach einem der vorangehenden Ansprüche, d a - d u r c h g e k e n n z e i c h n e t , daß die Kontaktgebiete (30) in der Sensorschicht (11) eine ineinanddergreifende Fingerstruktur (Kammstruktur) aufweisen.

7. Sensor nach einem der Ansprüche 1 bis 5, d a d u r c h g e k e n n z e i c h n e t , daß die Kontaktgebiete (35, 36) ringförmig ausgebildet sind.

8. Sensor nach einem der vorangehenden Ansprüche, d a - d u r c h g e k e n n z e i c h n e t , daß mehrere Sensorschichten isoliert voneinander hintereinander angeordnet sind.

9. Verfahren zur Herstellung der Sensoren nach den Ansprüchen 1 bis 4, d a d u r c h g e k e n n z e i c h n e t , daß man die polykristalline Schicht auf das Glassubstrat aufdampft, aufsputtert oder durch das Chemical-Vapour-Deposition-Verfahren aufbringt.

10. Verfahren nach Anspruch 9, d a d u r c h g e k e n n - z e i c h n e t , daß man auf das beschichtete Glassubstrat eine isolierende Schicht aufbringt, die man über photolithographische Belichtungs- und Ätzverfahren in den Kontaktgebieten entfernt, worauf man durch Eindringen von Dotierungsatomen den Widerstand der Polysiliciumschicht in diesem Ge-

biet verkleinert und eine Leiterverbindung nach außen herstellt.

11. Verfahren nach Anspruch 10, d a d u r c h   g e k e n n -
z e i c h n e t , daß der Widerstand in den Kontaktgebieten
30 Ohm/cm$^2$ beträgt, und daß man als Dotierungstome P, As und
B verwendet.

12. Anwendung der Sensoren nach einem der Ansprüche 1 bis
8, d a d u r c h   g e k e n n z e i c h n e t , daß man sie
zum Messen der Intensität elektromagnetischer Strahlung einsetzt.

13. Anwendung der Sensoren nach einem der Ansprüche 1 bis
8, d a d u r c h   g e k e n n z e i c h n e t , daß man
sie zur Messung der Intensität von Lichtstrahlen (Laser)
einsetzt.

14. Anwendung der Sensoren nach einem der Ansprüche 1 bis 8,
d a d u r c h   g e k e n n z e i c h n e t , daß man sie zur
Steuerung der Strahlungsintensität einsetzt.

15. Anwendung der Sensoren nach Anspruch 8, d a d u r c h
g e k e n n z e i c h n e t , daß man sie zur ortsaufgelösten
Intensitätsmessung einsetzt.

16. Anwendung der Sensoren nach Anspruch 8, d a d u r c h
g e k e n n z e i c h n e t , daß man sie zum Kontrollieren
der Lage eines Körpers im Raum einsetzt.

FIG.1

0125390

¹/₉

FIG.2

FIG.3

FIG.4

FIG.5

FIG. 6

FIG.7

0125390

5/9

pn-Üb.

FIG 8

0/g

0125390

$U_s^e$

211

220

230

$U_s^e$

215

FIG.14

51

52

50

## FIG.9

## FIG.10

0125390

FIG.11

41

42

45

43

44

$\mathcal{U}_a$

FIG.12

320

319

321 — $I \approx 0$ — "0"

322 — $I \approx 0$ — "0"

323 — $I > 0$ — "1"

324 — $I \approx 0$ — "0"

325

log. Zust.

$u$

FIG.13

a)

| | | log. Zust. |
| 22 | | "0" |
| 00 | 01 | |
| | 21 | "1" |
| 02 | 03 | |

b)

| | | |
| 00 | 11 | 315 "0" |
| | | 314 "1" |
| | | 313 "0" |
| | | 312 "0" |
| | | 311 "0" |
| | | 215 "0" |
| | | 214 "1" |
| | | 213 "0" |
| | | 212 "0" |
| 02 | | 211 "0" |

15
14
13
12
11

**0125390**

Europäisches
Patentamt

**EUROPÄISCHER RECHERCHENBERICHT**

Nummer der Anmeldung

EP 84 10 ı208

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| A | US-A-2 844 493  (H. SCHLOSSER) * Ansprüche 1, 7; Spalte 1, Zeile 66 - Spalte 2, Zeile 13 * | 1-3 | H 01 L   29/66 H 01 L   31/02 H 01 L   31/08 H 01 L   31/18 |
| A | DE-A-2 529 312  (POLAROID) * Ansprüche 1, 4; Seiten 5, 7, 18, 19; Figur 9 * | 1,2,5, 12-15 | |
| A | DE-A-2 835 136 (FRAUNHOFER-GESELLSCHAFT) * Ansprüche 1-4; Figuren 2A-2D * | 6,10 | |
| A | GB-A-2 104 289  (SECRETARY OF STATE FOR INDUSTRY) * Ansprüche 1, 2, 11 * | 1,13 | |

| | | | RECHERCHIERTE SACHGEBIETE (Int. Cl. 3) |
|---|---|---|---|
| A | US-A-4 180 618  (J.W. ALPHA et al.) * Spalte 2, Zeilen 17-29 * | 4,9-11 | H 01 L   29/66 H 01 L   31/02 H 01 L   31/08 |
| A | US-A-3 957 537  (A.C. BASKETT et al.) * Ansprüche 1, 2, 6; Figuren 1-4 * | 1,5,8 | H 01 L   31/18 |

Der vorliegende Recherchenbericht wurde für alle Patentansprüche erstellt.

| Recherchenort BERLIN | Abschlußdatum der Recherche 19-06-1984 | Prüfer ROTHER A H J |
|---|---|---|